# EUROPÄISCHE PATENTANMELDUNG

(11) **EP 2 320 240 A2**
(43) Veröffentlichungstag der Anmeldung: **11.05.2011**
(21) Anmeldenummer: 10014230.6
(22) Anmeldetag: 03.11.2010
(51) Int. Cl.: G01R 29/10

(54) **Verfahren und Vorrichtung zum Vermessen eines Strahlungsfelds**

(30) Priorität: 04.11.2009 DE 102009051969
(71) Anmelder: Astrium GmbH, 82024 Taufkirchen (DE)
(72) Erfinder: Eibert, Thomas, 81925 München (DE); Fritzel, Torsten, 81925 München (DE); Schmidt, Carsten, 80995 München (DE); Steiner, Hans-Jürgen, 81827 München (DE)
(74) Vertreter: Avenhaus, Beate

(57) **Zusammenfassung**

Die Erfindung beschreibt ein Verfahren zum Vermessen eines Strahlungsfelds (2) eines Messobjekts (1), welches insbesondere in der unmittelbaren Nähe des Messobjekts (1) durchgeführt wird. Eine oder mehrere Antennenmesssonde(n) (4) werden innerhalb des Strahlungsfelds (2) beliebig bewegt und dabei wird eine Anzahl an Hochfrequenzmesspunkten aufgenommen. Während der Bewegung der Antennenmesssonde (4) wird zeitgleich oder zeitnah mit der Aufnahme jeweiliger Hochfrequenzmesspunkte zumindest eine Positionsbestimmung einer jeweiligen Antennenmesssonde (4) durchgeführt, um einem jeweiligen Hochfrequenzmesspunkt eine Position zur Ermittlung einer räumlich definierten Messpunktwolke zuzuordnen. Schließlich können aus der räumlichen Messpunktwolke mittels eines Feldtransformationsverfahrens Strahlungsdiagramme in beliebiger Entfernung zum Messobjekts (1) bestimmt werden.

## Beschreibung

Die Erfindung betrifft ein Verfahren und eine daraus resultierende vereinfachte Vorrichtung zum Vermessen eines Messobjekts, insbesondere von Antennensystemen oder von ganzen Objekten in denen die Antennensysteme verbaut sind.

Antennenmessanlagen sind mit vielen und teils sehr teuren, antennenmessspezifischen Einrichtungen ausgestattet. Ferner sind die Messanlagen aufgrund ihres technischen Aufbaus und ihrer Größe in der Regel nicht portabel. Zur Vermessung eines Messobjekts, wie z.B. einer Antenne, müssen diese daher stets zur Messanlage gebracht und dort aufgebaut werden. Spontane und schnelle Vor-Ort-Messungen, z.B. von kleinen oder bereits an Satelliten oder an Flugzeugen vorgesehenen Antennen, sind daher kaum möglich.

Für Vor-Ort-Messungen einer Antenne werden üblicherweise sog. Testkappen verwendet, welche die Reproduzierbarkeit der Antennenfeldstärke an einer bestimmten Position vermessen. Es ist jedoch nicht möglich, das Strahlungsdiagramm einer Antenne mit einer solchen Testkappe zu ermitteln.

Aus der WO 2001/050145 ist es weiterhin bekannt, eine Antenne mittels einer schwebenden Plattform zu vermessen. Diese Plattform ist vorrangig für große Antennenstrukturen vorgesehen. Die Vermessung von kleinen Antennenstrukturen ist mit derartigen Plattformen jedoch nur schwer zu bewerkstelligen.

Es ist daher Aufgabe der vorliegenden Erfindung, ein Verfahren und eine Vorrichtung anzugeben, mit denen eine flexiblere Vermessung eines Strahlungsfelds eines Messobjekts, wie z.B. einer Antenne, ermöglicht wird. Insbesondere sollen das Verfahren und die Vorrichtung die Vermessung des elektromagnetischen Feldes in der unmittelbaren Nähe der Antenne an beliebigen Messpunkten innerhalb eines vorgegebenen Messvolumens ermöglichen und mittels einer schnellen und genauen Feldtransformation die Messpunkte in räumlich ebene und typischerweise äquidistante Strahlungsdiagrammewerte bei einem freizuwählenden Abstand zum Messobjekt umzuwandeln.

Diese Aufgaben werden gelöst durch ein Verfahren gemäß den Merkmalen des Patentanspruchs 1 und eine Vorrichtung gemäß den Merkmalen des Patentanspruchs 13. Vorteilhafte Ausgestaltungen ergeben sich aus den abhängigen Patentansprüchen.

Die Erfindung schafft ein Verfahren, mit dem eine oder mehrere Antennenmesssonden innerhalb des Strahlungsfelds bewegt werden und dabei eine Anzahl an räumlich beliebig verteilten Hochfrequenzmesspunkten aufnehmen. Während der Bewegung einer jeweiligen Antennenmesssonde wird zeitgleich oder zeitnah mit der Aufnahme jeweiliger Hochfrequenzmesspunkte zumindest eine Positionsbestimmung einer jeweiligen Antennenmesssonde durchgeführt, um einem jeweiligen Messpunkt eine Position zur Ermittlung einer räumlichen definierten Messpunktwolke zuzuordnen. Aus der räumlichen Messpunktwolke wird dann ein Strahlungsdiagramm des Messobjekts mittels eines Feldtransformationsverfahrens bestimmt.

Das Messverfahren eignet sich insbesondere für das kostengünstige Vermessen kleiner und mittelgroßer Messobjekte, wie z.B. Antennen oder streuende Objekte. Das Verfahren schafft Voraussetzungen für Antennen- oder Streuoptimierungen und eignet sich z.B. für die Fehlersuche mittels einer lokalen Diagnose von Antennenstrahlungseigenschaften im Zuge von Wartungs- und Reparaturarbeiten, wie z.B. an Fluggeräten und Satelliten. Ein Vorteil des Verfahrens liegt in der Flexibilität und in dem geringeren Kostenaufwand für die Vermessung des Strahlungsfelds eines Messobjekts. Insbesondere lassen sich aus der erzeugten räumlichen Messpunktwolke mittels des genannten Feldtransformationsverfahrens auch die in der Praxis gebräuchlichen Nah- und Fernfeld-Strahlungsdiagramme des Messobjekts ermitteln, bestehend aus räumlich ebenen und typischerweise äquidistant verteilten Strahlungsdiagrammwerten,

Während der Bewegung einer jeweiligen Antennenmesssonde wird zur Aufnahme eines jeweiligen Messpunkts eine Hochfrequenzmessung zur Charakterisierung der jeweiligen elektromagnetischen Feldkomponenten durchgeführt. Diese Messpunkte werden als Hochfrequenzmesspunkte bezeichnet.

Bei dem vorliegend beschriebenen Messverfahren wird ein spezielles Feldtransformationsverfahren verwendet, welches im Gegensatz zu bestehenden Verfahren aus der genannten Messdatenwolken in vertretbarer Zeit mit vertretbarem Aufwand und mit ausreichender Genauigkeit Antennenstrahlungsdiagramme mit beliebiger Entfernung zum Messobjekt ermitteln kann. Dieses Feldtransformationsverfahren basiert auf einer schnellen Strahlungsintegralberechnung, welches das Strahlungsfeld oder die Strahlungsfelder auf geeignete Ersatzquellendarstellungen, wie z.B. ebene Wellen oder räumliche elektrische und magnetische Stromverteilungen, zurückführen und über eine typischerweise hierarchische, mehrstufige Translation den Zusammenhang zu den gemessenen Hochfrequenzsignalen erzeugen können. Ein weiteres besonderes Kennzeichen dieses Verfahrens ist, dass es den Einfluss einer jeweiligen Antennenmesssonde auf die zu messenden Signale berücksichtigen kann, indem eine jeweilige Antennenmesssonde nur über ihre Fernfeldantennendiagramme nach Betrag und Phase charakterisiert wird. Ein weiteres Kennzeichen des angewandten Feldtransformationsverfahrens ist, dass dieses aus "Volumendaten" und nicht nur aus Flächendaten die Berechnung zur Ermittlung der Strahlungsdiagramme durchführen kann. Das eingesetzte Transformationsverfahren erlaubt optional eine zusätzliche Unterdrückung von eventuellen Raumreflexionen.

Gemäß einer weiteren zweckmäßigen Ausgestaltung ist eine jeweilige Antennenmesssonde mit einem Positionsziel versehen, dessen Position zur Positionsbestimmung der betreffenden Antennenmesssonde messtechnisch erfasst wird. Insbesondere wird zur Erfassung der Position des Positionsziels ein Lasermessstrahl oder ein Messarm und/oder ein Inertialmesssystem, ein geodätisches Messmittel oder ein auf Funknavigation basierendes Messverfahren verwendet.

Bei gekrümmten Messvolumina und/oder zur Erhöhung der Messqualität kann auch die Orientierung der Antennenmesssonde ermittelt werden insbesondere mittels entsprechender Erweiterung des Positionsmesssystems.

Die Bewegung einer jeweiligen Antennenmesssonde wird zweckmäßigerweise manuell durchgeführt. Durch die Portabilität der Antennenmesssonde und durch das handgeführte Bewegen kann das elektromagnetische Strahlungsfeld des Messobjekts in beliebiger Weise ermittelt werden. Die Position der Messpunkte innerhalb des Messvolumens ist nahezu beliebig wählbar, wobei die Positionen stets mit einem hochgenauen Positionsmesssystem ermittelt werden, um aus der Kombination von Position und aufgenommenem Hochfrequenzmesspunkt Strahlungsdiagramme des Messobjekts mittels des angegebenen Feldtransformationsverfahrens bestimmen zu können.

Gemäß einer weiteren zweckmäßigen Ausgestaltung wird auf einem Ausgabemittel die Messpunktdichte und Messpunktverteilung der Vermessung des Strahlungsfelds des Messobjekts kontinuierlich visualisiert. Hierdurch wird bei der handgeführten Bewegung einer jeweiligen Antennenmesssonde eine Kontrolle ermöglicht, in welchem Raum- oder Flächensegment Messpunkte bereits aufgenommen wurden und in welchem Raum- bzw. Flächensegment die Aufnahme von Messpunkten noch notwendig ist.

Gemäß einer weiteren zweckmäßigen Ausgestaltung wird die Anzahl der aufgenommenen Messpunkte derart gewählt, dass die Messpunktdichte und Messpunktverteilung den Anforderungen des Feldtransformationsverfahrens genügt, welches auf einer schnellen Strahlungsintegralberechnung basiert und den Einfluss der Messsonde auf die zu messenden Signale berücksichtigt.

Es ist weiterhin zweckmäßig, wenn bei der Bestimmung des Strahlungsdiagramms des Messobjekts Raumreflexionen unterdrückt werden. Hierdurch ist eine weiter verbesserte Bestimmung des Strahlungsfelds der Antenne möglich.

Gemäß einer weiteren zweckmäßigen Ausgestaltung wird eine jeweilige Antennenmesssonde innerhalb eines Messvolumens bewegt, welches den Strahlengang des Messobjektes umschließt. Die Antennenmesssonde(n) wird/werden dabei je nach Antennentyp innerhalb eines ebenen Messvolumens vor dem Messobjekt bewegt oder um das Messobjekt innerhalb eines gekrümmten Messvolumens herumgeführt. Letzteres Vorgehen wird insbesondere bei Antennen mit nichtbündelnder Strahlungscharakteristik gewählt.

Die Erfindung schafft weiter eine Vorrichtung zum Vermessen eines Strahlungsfelds eines Messobjekts, insbesondere innerhalb dessen unmittelbarer Nähe. Die Vorrichtung umfasst eine oder mehrere Antennenmesssonden, welche innerhalb des Strahlungsfelds zur Aufnahme einer Anzahl an Hochfrequenzmesspunkten bewegbar sind. Sie umfasst weiter ein Positionsbestimmungsmittel, mit dem während der Bewegung einer jeweiligen Antennenmesssonde zeitgleich oder zeitnah mit der Aufnahme jeweiliger Hochfrequenzmesspunkte zumindest eine Positionsbestimmung einer jeweiligen Antennenmesssonde durchführbar ist, um einem jeweiligen Messpunkt eine Position zur Ermittlung einer räumlichen Messpunktwolke zuzuordnen. Ferner ist eine Recheneinheit vorgesehen, mit der aus der räumlichen Messpunktwolke zumindest ein entfernungsabhängiges Strahlungsdiagramm des Messobjekts bestimmbar ist, wie z.B. Nah- und Fernfeldstrahlungsdiagramme.

Zweckmäßigerweise umfasst die Vorrichtung weiter ein Frequenzbestimmungsmittel, mit dem während der Bewegung der Antennenmesssonde zur Aufnahme eines jeweiligen Messpunkts eine Hochfrequenzmessung durchführbar ist.

Gemäß einer weiteren Ausgestaltung ist eine jeweilige Antennenmesssonde mit einem Positionsziel versehen, dessen Position zur Positionsbestimmung der Antennenmesssonde messtechnisch erfassbar ist. Zur Erfassung der Position des Positionsziels ist ein Lasermessstrahl, ein Messarm und/oder ein Inertialmesssystem vorgesehen. Prinzipiell können auch andere Möglichkeiten der Positionsbestimmung eingesetzt werden, wie z.B. geodätische Messmittel oder auf Funknavigation basierende Messverfahren.

Zweckmäßigerweise ist eine jeweilige Antennenmesssonde von Hand im Messvolumen schwenkbar, wodurch diese aufgrund ihrer Portabilität flexibel im Raum bewegbar ist, um das Strahlungsfeld, insbesondere in der unmittelbaren Nähe des Messobjekts zu erfassen. Mittels eines geeigneten Feldtransformationsverfahrens können dann z.B. entfernungsabhängige Nah- und Fernfeldstrahlungsdiagramme des Messobjekts bzw. der Antenne berechnet werden.

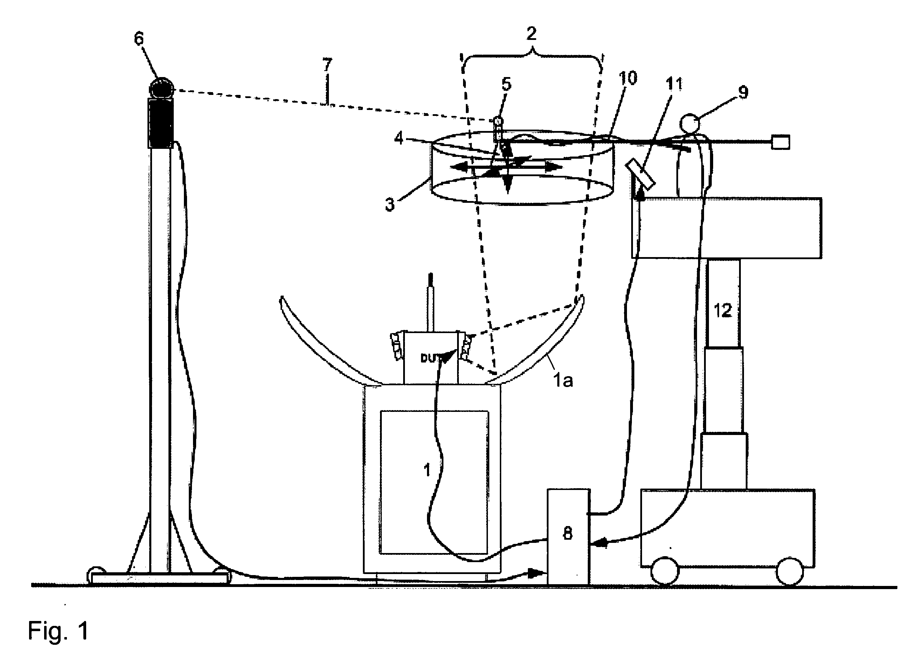

Die Erfindung wird nachfolgend näher anhand eines Ausführungsbeispiels in der Zeichnung erläutert.

Die einzige Figur zeigt in schematischer Darstellung eine Vorrichtung zum Vermessen eines Strahlungsfelds eines Messobjekts mit der Zielsetzung die damit gemessene Messpunktewolke in entfernungsabhängige Nah- und Fernfeldstrahlungsdiagramme zu transformieren.

Bei dem in der Figur mit dem Bezugszeichen 1 dargestellten Messobjekt handelt es sich beispielsweise um einen Telekommunikationssatelliten. Dessen in der Figur rechts dargestellte Antenne 1a vermessen werden soll. Die Antenne 1a erzeugt ein relativ hoch bündelndes, elektromagnetisches Strahlungsfeld 2, welches durch ein vorzugsweise horizontales Abtastvolumen hinreichend vollständig erfasst werden kann. Eine Antennensonde 4, welche mit einem Positionsziel 5 versehen ist, wird zusammen mit dem Positionsziel 5 innerhalb des energetisch relevanten Messvolumens 3 bewegt. Dabei wird eine Anzahl an Messpunkten aufgenommen, indem für jeden Messpunkt eine Hochfrequenzmessung durchgeführt wird. Das Strahlungsfeld der Antenne 1 a ist vollständig vermessen wenn die Anzahl der Messpunkte derart gewählt ist, dass die so erzielte räumliche Messpunktdichte und -verteilung den Anforderungen des angewandten Feldtransformationsverfahrens entspricht.

Während der Bewegung der Antennenmesssonde 4 wird entsprechend der notwendigen oder vorgegebenen Messpunktdichte zeitgleich mit der Aufnahme an Messpunkten eine Positionsmessung der Antennenmesssonde 4 durchgeführt. Zur Bestimmung der Position der Antennenmesssonde 4 kann ein Positionsmesssystem verwendet werden, welches z.B. einen sog. Lasertracker umfasst. Dieser besteht aus einem Bodengerät 6, welches über einen Lasermessstrahl 7 und dem an der Antennenmesssonde 4 angebrachten Positionsziel 5 die Position der Antennenmesssonde hochgenau vermisst. Es können jedoch auch andere Positionsmessgeräte eingesetzt werden, wie z.B. sog. Messarme.

Für Antennen mit einem bündelnden Strahlungsfeld wird die Antennenmesssonde 4 vorzugsweise senkrecht zur Ausbreitung des Strahlungsfelds 2 innerhalb eines energetisch relevanten Messvolumens 3 bewegt, wie dies durch die Pfeile in dem Messvolumen 3 gekennzeichnet ist. Für nicht-bündelnde Antennen oder omnidirektional reflektierende Objekte kann die Antennenmesssonde um das Messobjekt 1, bzw. deren Antenne 1a, herumgeführt werden. Das angewandte Feldtransformationsverfahren ermöglicht die Verwendung von Messpunkten, die sich an beliebiger Stelle innerhalb eines Messvolumens befinden und nicht entlang einer Oberfläche. Diese Eigenschaft trägt wesentlich zur Vereinfachung der Messung bei, da ein weiterer räumlicher Freiheitsgrad bei der Führung der Antennenmesssonde genutzt werden kann.

Für gekrümmte Messvolumina und/oder zur Erhöhung der Qualität der Messdaten kann mit z.B. einem erweiterten Positionsmesssystem zusätzlich die Orientierung der Antennenmesssonde 4 ermittelt werden. Die Positions- und optional die Orientierungsdaten werden zusammen mit den Messpunkten (d.h. den Hochfrequenzdaten) mit einer Recheneinheit 8 aufgezeichnet. Der Rechner 8 kann sich hierzu in einem entsprechenden Schrank (Rack) befinden. In diesem sind beispielsweise auch die entsprechenden Hochfrequenzmessgeräte, wie z.B. Sender und Empfänger, zur Aufnahme der räumlich verteilten Messpunkte angeordnet. Ferner können auch weitere Einheiten zur Unterdrückung von Raumreflexionen in dem Schrank vorgesehen sein, falls die Messungen in nicht Hochfrequenzen absorbierende Räumen durchgeführt werden.

Die Abtastung des elektromagnetischen Antennenfelds wird im Ausführungsbeispiel von einer Person 9 durchgeführt. Diese bewegt eine portable Antennenmesssonde 4 über eine Verlängerung 10 horizontal und vertikal hin und her. Über ein Ausgabemittel 11, z.B. ein Display, ist für die die Messung durchführende Person 9 ersichtlich, wie vollständig das Messvolumen 3 bereits abgetastet wurde. Über das Ausgabemittel 11 ist erkennbar, an welchen Orten weitere Abtastungen vorzunehmen sind. Die die Messung durchführende Person 9 steht z.B. auf einer fahrbaren Arbeitsbühne 12, mit der die Person mit der Antennenmesssonde 4 möglichst dicht an den Ort der Messung gebracht werden kann. Die Feldabtastung kann auch durch andere nicht-antennenmessspezifische Einrichtungen, wie z.B. manuelle oder kraftgetriebene Hilfsmechanismen bis hin zu eventuell existierenden Hebe-, Transport-, Kran- und Robotiksystemen vorgenommen werden.

Sobald die Abtastung des Strahlungsfelds abgeschlossen ist, werden die Messdaten (Hochfrequenzdaten und Positionsdaten, eventuell Orientierungsdaten der Antennenmesssonde) mit der Recheneinheit 8 in ein Antennenstrahlungsdiagramm umgerechnet. Insbesondere lässt sich aus den Messdaten (d.h. der Messpunktwolke) die Fernfeld- aber auch Nahfeldstrahlungsdiagramme für unterschiedliche Abstände zum Messobjekt unter Verwendung des beschriebenen Feldtransformationsverfahrens ermitteln. Die Messdaten können auch auf einer anderen Recheneinheit als der dargestellten Einheit 8 gespeichert, verarbeitet und in ein Antennenstrahlungsdiagramm transformiert werden.

Das erfindungsgemäße Vorgehen weist den Vorteil auf, dass die Position der im Raum bewegten portablen Antennenmesssonde 4 nahezu beliebig ist, was mit Antennennahfeldmesssystemen aus dem Stand der Technik nicht möglich ist. Um das Strahlungsdiagramm der Antenne bestimmen zu können, werden zeitgleich oder zeitnah für jede Messung Hochfrequenzdaten und die Position der Antennenmesssonde(n) ermittelt. Aus der somit erzeugten räumlichen Messpunktwolke vor bzw. um das Messobjekt herum, können dann die gewünschten Strahlungsdiagramme in beliebiger Entfernung zur Antenne in vertretbarer Zeit mit vertretbarem Aufwand und mit ausreichender Genauigkeit berechnet werden. Insbesondere ist dann die Berechnung von Fernfeldstrahlungsdiagrammen möglich, welche letztendlich in den meisten Fällen von Interesse sind.

Die Erfindung zeichnet sich durch eine hohe Flexibilität durch die Portabilität der Vorrichtung zum Vermessen des Sendefelds und/oder der Empfangscharakteristik von Antennen oder von streuenden Objekten aus. Hierdurch ergibt sich ein geringerer Kostenaufwand für die Vermessung des relevanten Strahlungsfeldes. Insbesondere eignet sich das beschriebene Vorgehen zum Vermessen kleinerer und mittelgroßer Antennen, welche beispielsweise an Satelliten oder an Flugzeugen angebracht sind. Das Verfahren sowie die Vorrichtung können zur Antennenoptimierung und Fehlersuche sowie zur lokalen Diagnose von Antennenstrahlungseigenschaften eingesetzt werden.

Die Erfindung nutzt ein Verfahren zum Vermessen eines direkten, reflektierten oder gestreuten Strahlungsfelds eines Messobjekts mittels Messung von räumlich beliebig verteilten Messpunkten, vorzugsweise in unmittelbarer Nähe des Messobjektes und innerhalb eines dreidimensionalen Messvolumens, welches das zu messende Strahlungsfeld des Messobjektes umschließt. Insbesondere handelt es sich bei den Messobjekten um einzelne oder an einem Objekt integrierte Antennenstrukturen. Hierbei werden pro Messpunkt vorzugsweise mittels einer oder mehrerer Antennenmesssonden, die jeweiligen elektromagnetischen Feldkomponenten gemessen und zeitgleich oder zeitnah die genaue räumliche Position der Antennenmesssonde(n) bestimmt. Zur Verbesserung der Messergebnisse kann auch pro Messpunkt zusätzlich die Orientierung der Antennenmesssonde(n) bestimmt werden. Aus der somit elektromagnetisch und räumlich definierten Messpunktwolke werden mittels des nachfolgend beschriebenen Feldtransformationsverfahrens Antennenstrahlungsdiagramme bestimmt in beliebigen Abständen zum Messobjekt, welche die in der Praxis bekannten Nahfeld- und Fernfelddiagramme einschliessen.

Bei dem vorliegend beschriebenen Messverfahren wird ein spezielles Feldtransformationsverfahren verwendet, welches im Gegensatz zu bestehenden Verfahren aus der genannten Messdatenwolken in vertretbarer Zeit mit vertretbarem Aufwand und mit ausreichender Genauigkeit Antennenstrahlungsdiagramme mit beliebiger Entfernung zum Messobjekt ermitteln kann. Dieses Feldtransformationsverfahren basiert auf einer schnellen Strahlungsintegralberechnung, welches das Strahlungsfeld oder die Strahlungsfelder auf geeignete Ersatzquellendarstellungen, wie z.B. ebene Wellen oder räumliche elektrische und magnetische Stromverteilungen, zurückführen und über eine typischerweise hierarchische, mehrstufige Translation den Zusammenhang zu den gemessenen Hochfrequenzsignalen erzeugen können. Ein weiteres besonderes Kennzeichen dieses Verfahrens ist, dass es den Einfluss einer jeweiligen Antennenmesssonde auf die zu messenden Signale berücksichtigen kann, indem eine jeweilige Antennenmesssonde nur über ihre Fernfeldantennendiagramme nach Betrag und Phase charakterisiert wird. Ein weiteres Kennzeichen des angewandten Feldtransformationsverfahrens ist, dass dieses aus "Volumendaten" und nicht nur aus Flächendaten die Berechnung zur Ermittlung der Strahlungsdiagramme durchführen kann. Das eingesetzte Transformationsverfahren erlaubt optional eine zusätzliche Unterdrückung von eventuellen Raumreflexionen. Ferner können alle Arten von einzelnen oder integrierten Antennen für den Sende- und/oder Empfangsbetrieb und von streuenden Messobjekten strahlungstechnisch charakterisiert werden.

## Patentansprüche

1. Verfahren zum Vermessen eines Strahlungsfelds (2) eines Messobjekts (1), insbesondere in der unmittelbaren Nähe des Messobjekts (1), bei dem
- eine oder mehrere Antennenmesssonden (4) innerhalb des Strahlungsfelds (2) bewegt werden und dabei eine Anzahl an räumlich verteilten Hochfrequenzmesspunkten aufgenommen wird;
- während der Bewegung der Antennenmesssonde (4) zeitgleich oder zeitnah mit der Aufnahme jeweiliger Hochfrequenzmesspunkte zumindest eine Positionsbestimmung einer jeweiligen Antennenmesssonde (4) durchgeführt wird, um einem jeweiligen Hochfrequenzmesspunkt eine Position zur Ermittlung einer räumlich definierten Messpunktwolke zuzuordnen;
- aus der räumlich aufgenommenen Messpunktwolke mit einem Feldtransformationsverfahren zumindest ein Strahlungsdiagramm in beliebiger Entfernung zum Messobjekt (1) bestimmt wird.

2. Verfahren nach Anspruch 1, bei dem ein Feldtransformationsverfahren angewandt wird, das auf einer schnellen Strahlungsintegralberechnung basiert, die das Strahlungsfeld oder die Strahlungsfelder auf geeignete Ersatzquellendarstellungen, insbesondere ebene Wellen oder räumliche elektrische und magnetische Stromverteilungen, zurückführen und über eine, insbesondere hierarchische, mehrstufige Translation einen Zusammenhang zu den gemessenen Hochfrequenzmesspunkten erzeugen.

3. Verfahren nach Anspruch 1 oder 2, bei dem eine jeweilige Antennenmesssonde (4) mit einem Positionsziel (5) versehen ist, dessen Position zur Positionsbestimmung der betreffenden Antennenmesssonde (4) messtechnisch erfasst wird.

4. Verfahren nach Anspruch 3, bei dem zur Erfassung der Position des Positionsziels (5) ein Lasermessstrahl (7), ein Messarm und/oder ein Inertialmesssystem, ein geodätische Messmittel oder ein auf Funknavigation basierendes Messverfahren verwendet wird.

5. Verfahren nach einem der vorhergehenden Ansprüche, bei dem die Orientierung einer jeweiligen Antennenmesssonde (4) ermittelt wird.

6. Verfahren nach einem der vorhergehenden Ansprüche, bei dem die Bewegung einer jeweiligen Antennenmesssonde (4) manuell oder durch nicht-antennenmessspezifische Hilfseinrichtungen durchgeführt wird.

7. Verfahren nach einem der vorhergehenden Ansprüche, bei dem auf einem Ausgabemittel (11) eine Messpunktdichte und Messpunktverteilung kontinuierlich visualisiert wird.

8. Verfahren nach einem der vorhergehenden Ansprüche, bei dem die Anzahl der aufgenommenen Messpunkte derart gewählt wird, dass die Messpunktdichte und Messpunktverteilung den Anforderungen des verwendeten Feldtransformationsverfahrens genügt, das auf einer schnellen und genauen Strahlungsintegralberechnung basiert und bei dem der Einfluss der Messsonde auf die zu messenden Signale berücksichtigt wird.

9. Verfahren nach einem der vorhergehenden Ansprüche, bei dem bei der Bestimmung des Strahlungsdiagramms des Messobjekts (1) Raumreflexionen unterdrückt werden.

10. Verfahren nach einem der Ansprüche 1 bis 9, bei dem eine jeweilige Antennenmesssonde (4) in einem Messvolumen (3) bewegt wird, welches das Strahlungsfeld (2) umschließt und welches sich bevorzugt senkrecht zur Ausbreitung des Strahlungsfelds erstreckt.

11. Verfahren nach einem der Ansprüche 1 bis 9, bei dem eine jeweilige Antennenmesssonde (4) entlang einer Messebene bewegt wird, welches das Strahlungsfeld (2) umschließt.

12. Verfahren nach einem der Ansprüche 1 bis 9, bei dem eine jeweilige Antennenmesssonde (4) um das Messobjekt (1) herum geführt wird.

13. Vorrichtung zum Vermessen eines Strahlungsfelds (2) eines Messobjekts (1), insbesondere in der unmittelbaren Nähe des Messobjekts (1), umfassend:
- eine oder mehrere Antennenmesssonden (4), welche innerhalb des Strahlungsfelds (2) zur Aufnahme einer Anzahl an Hochfrequenzmesspunkten bewegbar sind;
- ein Positionsbestimmungsmittel (6), mit dem während der Bewegung der Antennenmesssonde(n) (4) zeitgleich oder zeitnah mit der Aufnahme jeweiliger Hochfrequenzmesspunkte zumindest eine Positionsbestimmung der Antennenmesssonde(n) (4) durchführbar ist, um einem jeweiligen Hochfrequenzmesspunkt eine Position zuzuordnen für die Erstellung einer räumlich definierten Messpunktwolke;
- eine Recheneinheit (8), mit der aus der räumlich definierten Messpunktwolke zumindest ein Strahlungsdiagramm des Messobjekts (1) bestimmbar ist.

14. Vorrichtung nach Anspruch 13, bei der die Antennenmesssonde ein Frequenzbestimmungsmittel umfasst, mit dem während der Bewegung einer jeweiligen Antennenmesssonde (4) zur Aufnahme eines jeweiligen Messpunkts eine Hochfrequenzmessung durchführbar ist.

15. Vorrichtung nach Anspruch 13 oder 14, bei der eine jeweilige Antennenmesssonde (4) mit einem Positionsziel (5) versehen ist, dessen Position zur Positionsbestimmung der Antennenmesssonde (4) messtechnisch erfassbar ist.

16. Vorrichtung nach Anspruch 15, bei der zur Erfassung der Position des Positionsziels (5) ein Lasermessstrahl (7), ein Messarm und/oder ein Inertialmesssystem, ein geodätisches Messmittel oder ein auf Funknavigation basierendes Messverfahren vorgesehen ist.

17. Vorrichtung nach einem der Ansprüche 13 bis 16, bei der eine jeweilige Antennenmesssonde (4) von Hand betätigbar ist oder durch nicht-antennenmessspezifische Hilfseinrichtungen bewegbar ist.
